**Europäisches Patentamt**

**European Patent Office**

**Office européen des brevets**

(19)

(11) Veröffentlichungsnummer: **0 008 371**

**A1**

(12) # EUROPÄISCHE PATENTANMELDUNG

(21) Anmeldenummer: **79102548.9**

(22) Anmeldetag: **19.07.79**

(51) Int. Cl.³: **G 01 R 15/10**
G 01 R 19/04, G 01 R 19/22
G 06 G 7/24

(30) Priorität: **22.08.78 DE 2836656**

(43) Veröffentlichungstag der Anmeldung:
**05.03.80 Patentblatt 80/5**

(84) Benannte Vertragsstaaten:
**AT BE CH DE FR GB IT LU NL SE**

(71) Anmelder: **Licentia Patent-Verwaltungs-GmbH**
**Theodor-Stern-Kai 1**
**D-6000 Frankfurt/Main 70(DE)**

(72) Erfinder: **Klussmann, Karl-Heinz**
**Am Leineufer 1**
**D-3203 Sarstedt/Schliekum(DE)**

(74) Vertreter: **Einsel, Robert, Dipl.-Ing.**
**Licentia Patent-Verwaltungs-GmbH Theodor-Stern-Kai**
**1**
**D-6000 Frankfurt/Main 70(DE)**

(54) Schaltungsanordnung mit einer Gleichrichterschaltung und einem logarithmischen Verstärker.

(57) Zwei an sich bekannte Schaltungen, ein logarithmischer Verstärker und ein aktiver Gleichrichter, werden mit einem einzigen Operationsverstärker aufgebaut.

Eingangsteiler | Logarithmierer und Gleichrichter | Treiber mit Leuchtdioden

EP 0 008 371 A1

Croydon Printing Company Ltd.

- 2 -

Licentia Patent-Verwaltungs-GmbH
Theodor-Stern-Kai 1
6000 Frankfurt/Main 70

Hannover,den 10.08.1978
KE2-H Tr/vß      H 78/32

## Schaltungsanordnung mit einer Gleichrichterschaltung und einem logarithmischen Verstärker

In der Nachrichtentechnik besteht vielfach die Aufgabe, eine in einem großen Bereich veränderliche Wechselspannung mittels einer Anzeigeeinrichtung anzuzeigen. Wegen des großen anzuzeigenden Spannungsbereiches ist eine logarithmische Anzeige erforderlich. Logarithmische Verstärker sind an sich bekannt. Ein bekannter Logarithmierer (siehe "Halbleiterschaltungstechnik", der Verfasser Tietze-Schenk) ist z.B. mit einem Operationsverstärker aufgebaut, der mittels eines Widerstands-Dioden-Netzwerkes derart gegengekoppelt ist, daß die logarithmische Kennlinie angenähert wird.

Der anzuzeigende Spannungsbereich reicht beispielsweise von 10 mV bis 1 V, entsprechend einem Anzeigebereich von 40 dB. Eine Halbleiterdiode ist nicht in der Lage, Spannungen im Millivoltbereich gleichzurichten. Daher ist ein aktiver Gleichrichter erforderlich. Ein bekannter aktiver Gleichrichter (siehe "Operationsverstärker" von Hansjürgen Vohldiek) ist mit einem Operationsverstärker aufgebaut. Im Gegenkopplungsweg des Operationsverstärkers liegt eine Halbleiterdiode. Eine weitere Halbleiterdiode führt vom Ausgang des Operationsverstärkers zum Ausgang des aktiven Gleichrichters. Vom Ausgang des aktiven Gleichrichters zu dem Eingang des Operationsverstärkers, an dem die gegenkoppelnde Diode liegt, führt ein Gegenkopplungswiderstand.

Es ist bekannt (siehe Funkschau 1973, Heft 26, S. 1019 und 1020), einen Gleichrichter der bekannten Art und einen Logarithmierer hintereinander zu schalten und auf diese Weise eine anzuzeigende Wechselspannung zunächst gleichzurichten und anschließend logarithmisch zu verstärken. Bei der bekannten Schaltung sind zur logarithmischen Anzeige einer Wechselspannung drei Operationsverstärker und eine Menge weiterer Bauteile erforderlich.

Der Erfindung liegt die Aufgabe zugrunde, aus einer in einem großen Bereich veränderlichen Wechselspannung auf einfachere Weise eine logarithmische Gleichspannung zu gewinnen, die z.B. für Anzeigezwecke verwendet werden kann.

Diese Aufgabe wird durch die im Patentanspruch 1 angegebene Erfindung gelöst. Die erfindungsgemäße Schaltungsanordnung ist mit einem einzigen Operationsverstärker aufgebaut. Als Grundlage für die Schaltung dient die schon erwähnte, für sich bekannte aktive Gleichrichterschaltung. Diese Gleichrichterschaltung ist zusätzlich mit einem Gegenkopplungsweg vom Ausgang der Gleichrichterschaltung auf den Eingang versehen, der der Gesamtschaltung eine logarithmische Verstärkungscharakteristik gibt.

Gemäß einem im Anspruch 2 angegebenen besonders vorteilhaften Ausführungsbeispiel der Erfindung ist in dem Gegenkopplungsweg der Gleichrichterschaltung ein Widerstands-Dioden-Netzwerk gelegt, wie es an sich bei einer nur der Logarithmierung dienenden Schaltung, z.B. aus der schon erwähnten Veröffentlichung "Halbleitertechnik", Tietze-Schenk, bekannt ist.

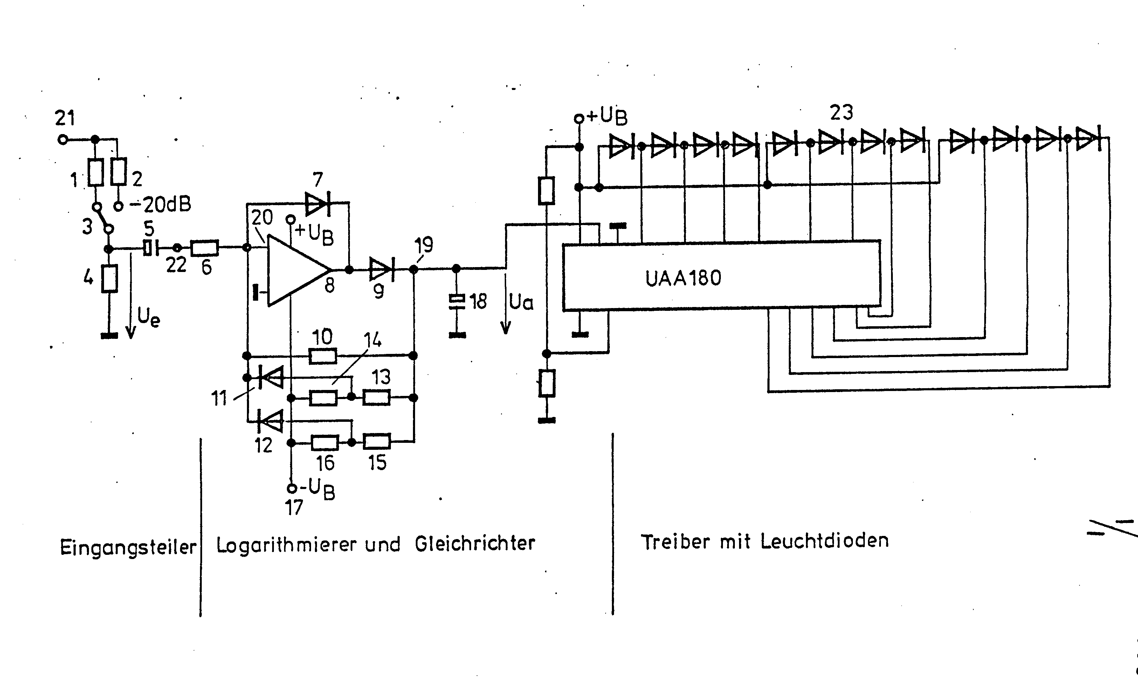

Die Erfindung wird im folgenden anhand eines in der Zeichnung dargestellten Ausführungsbeispieles erläutert.
Die Zeichnung zeigt eine Schaltung zur Aussteuerungsanzeige, die die erfindungsgemäßen Merkmale enthält.

Die dargestellte Schaltung enthält einen Eingangsteiler, einen Logarithmierer und Gleichrichter mit den erfindungsgemäßen Merkmalen und eine Treiberschaltung mit Leuchtdioden als Anzeigeeinrichtung, die mit einer bekannten integrierten Schaltung aufgebaut ist. Dem Eingangsteiler ist von einer Eingangsklemme 21 das anzuzeigende Signal vom Ausgang eines Niederfrequenz-Endverstärkers (nicht dargestellt) zugeführt. Die vom
Ausgang des Endverstärkers zugeführte Spannung beträgt bei Nennleistung des Endverstärkers ca. 20 Volt und würde den Logarithmierer übersteuern. Die Ausgangsspannung wird deshalb auf 1 V
heruntergeteilt. Dazu dienen die Widerstände 1,2 und 4. Mittels
eines Umschalters 3 kann die Empfindlichkeit um 20 dB erhöht
werden. Die so heruntergeteilte Spannung ist über einen Kondensator 5 dem Gleichrichter und Logarithmierer zugeführt. Der
Anzeigebereich der Schaltungsanordnung beträgt 40 dB. Bei einer
maximalen Eingangsspannung von 1 Volt ergibt sich eine minimale
Eingangsspannung von 10 mVolt. Die Eingangswechselspannung wird
in einem aktiven Gleichrichter aus dem Operationsverstärker 8,
den Dioden 7 und 9 und den Widerständen 6 und 10 gleichgerichtet und schließlich in einem Kondensator 18 geglättet. Die
Ausgangsspannung ist mit Ua bezeichnet.
Der mit 22 bezeichnete Verbindungspunkt zwischen dem Kondensator 5 und dem Widerstand 6 stellt den Eingang des Gleichrichters dar und der zum Glättungskondensator gewändte Anschluß
der Dioden 9 (Schaltungspunkt 19) den Ausgang. Die verwendete
Gleichrichterschaltung ist an sich bekannt und braucht daher
nicht im einzelnen erläutert zu werden.

Vom Ausgang der Gleichrichterschaltung zum mit 20 bezeichneten
nichtinvertierenden Eingang des Operationsverstärkers 8 ist ein
Widerstands-Dioden-Netzwerk gelegt, mittels dessen die Gleichrichterschaltung so gegengekoppelt wird, daß sie eine logarithmische Verstärkungskennlinie erhält. Das Netzwerk enthält
zwei Spannungsteiler aus den Widerständen 13,14 und 15,16, die
vom Ausgang 19 gegen die über eine Eingangsklemme 17 zugeführte
negative Betriebsspannung $-U_B$ des Operationsverstärkers 8 geschaltet sind. Vom Abgriffpunkt der Spannungsteiler führen je
eine Diode 11 bzw. 12 zum invertierenden Eingang 20 des Operationsverstärkers 8. Durch dieses Widerstands-Dioden-Netzwerk
wird die Verstärkung zur Erreichung einer logarithmischen Kennlinie spannungsabhängig geändert. Im unteren Kennlinienbereich wird die Verstärkung durch die Widerstände 6 und 10 bestimmt.
Mit zunehmender Ausgangsspannung der Gleichrichterschaltung
wird zunächst der Widerstand 13 und mit weiter steigender Ausgangsspannung der Widerstand 15 zum Widerstand 10 parallel
geschaltet, wobei die Dioden 11 und 12 als Schaltdioden wirken. Der Schaltpunkt der Diode 11 bzw 12 ist vorgegeben durch
ihre Vorspannung, die durch das Teilungsverhältnis des Spannungsteilers 13,14 bzw. 15,16 vorbestimmt ist.

Die Ausgangsspannung $U_a$ am Kondensator 18 ist einer mit der bekannten integrierten Schaltung UAA 180 aufgebauten linearen
Pegelanzeigeschaltung zugeführt. Der Kondensator 18 bewirkt
eine Rücklaufverzögerung der Anzeige. Für Vollaussteuerung der
mit 23 bezeichneten LED-Zeile beträgt die Spannung am Kondensator 18 z.B. 3 Volt. Im folgenden wird ein Bemessungsbeispiel
für die beschriebene Schaltung wiedergegeben:
Widerstand 1: 15 k
Widerstand 2: 820 Ohm
Widerstand 4: 560 Ohm
Widerstand 6: 10k
Widerstand 10: 150 k
Widerstand 13: 390 k
Widerstand 14: 22 k
Widerstand 16: 560 k
Widerstand 15: 56 k
Kondensator 5: 2,2 $\mu$F
Kondensator 18: 22 $\mu$F
Dioden 7,9,11,12: Silizium-Dioden

Die erfindungsgemäße Schaltungsanordnung eignet sich nicht nur
für eine Aussteuerungsanzeige, sondern kann überall da angewandt
werden, wo aus einer Wechselspannung eine logarithmisch sich
ändernde Gleichspannung gewonnen werden soll.

P a t e n t a n s p r ü c h e

1. Schaltungsanordnung enthaltend eine Gleichrichterschaltung
und einen logarithmischen Verstärker, wobei die Gleichrichterschaltung aus einem Operationsverstärker aufgebaut ist
mit einer ersten Diode im Gegenkopplungszweig, einer zweiten Diode, die zwischen den Ausgang des Operationsverstärkers und die Ausgangsklemme der Gleichrichterschaltung geschaltet ist, und einem Widerstand zwischen der Ausgangsklemme und demjenigen Eingang des Operationsverstärkers, an
dem die erste Diode angeschlossen ist, dadurch gekennzeichnet, daß zwischen die Ausgangsklemme (19) der Gleichrichterschaltung und den Eingang des Operationsverstärkers (20)
der Gleichrichterschaltung ein Gegenkopplungs-Netzwerk (11
bis 16) geschaltet ist, das der Gleichrichterschaltung zusätzlich zur Gleichrichter-Charakteristik einen logarithmischen Kennlinien-Verlauf verleiht.

2. Schaltungsanordnung nach Anspruch 1, dadurch gekennzeichnet,
daß das Gegenkopplungs-Netzwerk (11 bis 16) mehrere von der
Ausgangsklemme (19) der Gleichrichterschaltung gegen ein
festes Bezugspotential $(-U_B)$ geschaltete Spannungsteiler
(14,13;15,16) enthält, daß vom Abgriffpunkt der Spannungsteiler zum Eingang (20) des Operationsverstärkers Dioden
(11,12) geschaltet sind, daß die Teilungsverhältnisse der
Spannungsteiler (14,13;15,16) so gewählt sind, daß die Dioden
(11,12) mit zunehmender Ausgangsspannung der Gleichrichterschaltung nacheinander leitend werden, derart, daß sie das
Gegenkopplungs-Netzwerk (11 bis 16) zur Annäherung an einen
logarithmischen Kennlinien-Verlauf umschalten.

Eingangsteiler | Logarithmierer und Gleichrichter | Treiber mit Leuchtdioden

**Europäisches Patentamt**

# EUROPÄISCHER RECHERCHENBERICHT

Nummer der Anmeldung

EP 79 102 548.9

| EINSCHLÄGIGE DOKUMENTE | | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | |
| | DE - B - 2 237 111 (HARTMANN & BRAUN) <br> * Spalte 1, Zeile 47 bis Zeile 64; <br> Fig. 1 * <br> -- <br> US - A - 3 483 475 (B.C. MITCHELL) <br> * Spalte 2, Zeile 41 bis Zeile 56; <br> Spalte 3, Zeile 37 bis Zeile 64; <br> Fig. 3 * <br> -- <br> RADIO FERNSEHEN ELEKTRONIK, Band 24, <br> Nr. 4, 1975 <br> Berlin <br> G. WINKLER "Aussteuerungsmesser mit <br> Operationsverstärkern" <br> * Seiten 127 bis 128 * <br> -- | 1,2 <br><br><br><br> 1,2 <br><br><br><br><br> 1,2 | G 01 R 15/10 <br> G 01 R 19/04 <br> G 01 R 19/22 <br> G 06 G 7/24 |
| A | US - A - 3 971 984 (S.M. BENCH) <br> * Fig. 1, Position 10a * <br> -- | | **RECHERCHIERTE SACHGEBIETE (Int. Cl.³)** <br> G 01 R 13/00 <br> G 01 R 15/10 <br> G 01 R 19/04 <br> G 01 R 19/22 <br> G 06 G 7/24 <br> H 03 F 3/00 <br> H 03 G 3/20 |
| A | US - A - 3 500 198 (A. KAISER et al.) <br> * Fig. 2, Positionen 15, 16 * <br> ---- | | |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. | |
|---|---|---|
| **Recherchenort** Berlin | **Abschlußdatum der Recherche** 15-11-1979 | **Prüfer** LEMMERICH |

EPA form 1503.1 06.78